# EUROPEAN PATENT APPLICATION

(11) **EP 3 915 963 A1**
(43) Date of publication of application: **01.12.2021**
(21) Application number: 19917789.0
(22) Date of filing: 27.12.2019
(51) Int. Cl.: C04B 35/584, H05K 1/03

(54) **SILICON NITRIDE, CERAMIC SLURRY AND PREPARATION METHOD**

(30) Priority: 05.03.2019 CN 201910164306
(71) Applicant: Qingdao Cup New Materials Co., Ltd., Qingdao, Shandong 266200 (CN)
(72) Inventor: CUI, Wei, Beijing 100020 (CN); CHENG, Huiming, Beijing 100020 (CN); ZOU, Yifeng, Beijing 100020 (CN); LI, Fei, Beijing 100020 (CN); ZHANG, Jie, Beijing 100020 (CN)
(74) Representative: Gille Hrabal Partnerschaftsgesellschaft mbB Patentanwälte
(86) International application number: PCT/CN2019/129452
(87) International publication number: WO 2020/177465

(57) **Abstract**

Disclosed is a silicon nitride powder, a preparation method thereof, a ceramic slurry containing the silicon nitride powder and a preparation method thereof. The surface area ratio of non-oxidized silicon nitride of the silicon nitride powder with respect to the total silicon nitride surface area is 0.40-0.85. The ceramic slurry comprises the silicon nitride powder, a sintering aid, and an organic component having a hydroxyl group, a carboxyl group, an amino group, an ester group, an aldehyde group, a carbonyl group, and other groups. The preparation method of the ceramic slurry comprises: (1) preparing silicon nitride primary powder via a temperature-controlled activation combustion synthesis method; (2) coarse screening the silicon nitride primary powder and acid-washing the same with an acid mixture of nitric acid, hydrochloric acid and sulfuric acid, followed by washing with water, suction filtering and drying; (3) placing the powder obtained from step 2 in a heating device and heat-treating the same under a flowing nitrogen atmosphere to remove additives; and (4) mixing the powder obtained from step 3 with a fluid, followed by grinding in a grinder and then sieving to obtain the product.

## Description

The present application claims the priority of the prior application NO.201910164306.3 submitted to China National Intellectual Property Administration on March 5, 2019 which is entitled "SILICON NITRIDE, CERAMIC SLURRY AND PREPARATION METHOD". The entire contents of the prior application are incorporated herein by reference.

### TECHNICAL FIELD

The present invention relates to silicon nitride, silicon nitride ceramic slurry and its preparation method, and in particular to a silicon nitride ceramic slurry for substrate and its preparation method, which belongs to the field of ceramic materials.

### BACKGROUND ART

With the high development of energy, space technology, new energy power and high-speed ground transportation and other technologies, the demand for high-power electronics is increasing day by day. Substrates are the core components of integrated circuits for power electronics devices. Under complex and harsh usage conditions, the stability of the substrate is affected by the combined effect of extreme thermal and mechanical stresses, and existing substrate materials do not have both good thermal shock resistance and good mechanical strength, so there is an urgent need for materials with excellent thermal conductivity and mechanical properties to be used in the field of substrate manufacturing.

Silicon nitride ceramics have many excellent properties such as low density, low coefficient of expansion, high thermal conductivity, high hardness, good thermal and chemical stability, corrosion resistance, and wear resistance, which are well suited for the application of power modules for high-power electronic devices. High thermal conductivity and high mechanical strength (bending strength and fracture toughness) of silicon nitride substrates can have a high service life and higher reliability under harsh operating conditions, making electronic power systems more secure and reliable during operation.

### SUMMARY OF THE DISCLOSURE

An aspect of the present invention provides a silicon nitride powder that, in the silicon nitride powder, a ratio of unoxidized silicon nitride surface area to entire silicon nitride surface area is from 0.40 to 0.85; preferably, the ratio of the unoxidized silicon nitride surface area to the entire silicon nitride surface area is from 0.50 to 0.80; further preferably, the ratio of the unoxidized silicon nitride surface area to the entire silicon nitride surface area is from 0.55 to 0.76.

According to an aspect of the present invention, the silicon nitride powder has a particle size in the range of from 0.4 µm to 20 µm; preferably from 1 µm to 10 µm; further preferably from 1.3 µm to 5 µm.

According to an aspect of the present invention, the silicon nitride powder has a specific surface area of 0.5 m²/g - 8.0 m²/g; preferably, the silicon nitride powder has a specific surface area of 0.8 m²/g - 6.0 m²/g; preferably, the silicon nitride powder has a specific surface area of 1.0 m²/g - 5.0 m²/g; preferably, the silicon nitride powder has a specific surface area of 1.1 m²/g - 4.0 m²/g.

According to an aspect of the present invention, the silicon nitride powder has an α phase content of >60 wt%, preferably >80 wt%, more preferably 85 wt% - 95 wt %.

An aspect of the present invention provides a ceramic slurry, the ceramic slurry comprises a silicon nitride powder as described above, a sintering aid and an organic component, wherein the organic component has a hydroxyl, carboxyl, amino, ester, aldehyde and/or carbonyl group; preferably, the organic component has a hydroxyl, carboxyl, amino and/or ester group; further preferably, the organic component has a hydroxyl and/or carboxyl group.

According to an aspect of the present invention, the organic component comprises a solvent, a dispersant, a binder and a plasticizer; preferably, a mass ratio of the silicon nitride powder, the sintering aid, the solvent, the dispersant, the binder and the plasticizer is 100 : ( 3-15) : (20-70) : (2-4) : (5-20) : (5-30).

According to an aspect of the present invention, the sintering aid is at least one selected from the group consisting of alumina, yttrium oxide, magnesium oxide, calcium oxide and magnesium silica nitrogen; preferably, the solvent is at least one selected from the group consisting of ethanol, ethylene glycol, isopropanol, n-butanol and 2-butanone; preferably, the dispersant is at least one selected from the group consisting of triethyl phosphate, polyvinylpyrrolidone, ammonium polyacrylate and ammonium citrate; preferably, the binder is at least one selected from the group consisting of polyethylene glycol, polyvinyl butyral and methyl acrylate; preferably, the plasticizer is at least one selected from the group consisting of phthalate, polyethylene glycol and glycerol.

According to an aspect of the present invention, the ceramic slurry has an impurity content of less than 5 wt%, a solid phase volume fraction of 50 %-75 % and a viscosity of less than 0.2 pa·s.

An aspect of the present invention provides a method for preparing silicon nitride powder, the method comprises:
(1) preparing a silicon nitride primary powder by a temperature-controlled activation combustion synthesis method;
(2) sieving the silicon nitride primary powder, washing with a mixture of nitric acid, hydrochloric acid and sulfuric acid, followed by washing with water, filtration and drying;
(3) placing powder obtained in step (2) in a heating device and removing the additives by heat treatment under flowing nitrogen;
(4) mixing powder obtained in step (3) with a fluid for surface shaping and sieving to obtain a slurry containing silicon nitride powder, the fluid comprising organic matter;
(5) heating the slurry containing silicon nitride powder obtained in step (4) in an oxygen-free environment, removing the fluid, sealing and packaging to obtain the silicon nitride powder described above.

An aspect of the present invention provides a method of preparing a silicon nitride ceramic slurry, the method comprises steps of:
(1) preparing a silicon nitride primary powder by a temperature-controlled activation combustion synthesis method;
(2) sieving the silicon nitride primary powder, washing with a mixture of nitric acid, hydrochloric acid and sulfuric acid, followed by washing with water, filtration and drying;
(3) placing powder obtained in step (2) in a heating device and removing the additives by heat treatment under flowing nitrogen;
(4) mixing powder obtained in step (3) with a fluid for surface shaping and sieving to obtain the silicon nitride ceramic slurry, the fluid comprising organic matter.

Wherein, in the above method of preparing silicon nitride powder and the method of preparing silicon nitride ceramic slurry, a particle size range of high-purity α silicon nitride powder prepared by the temperature-controlled activation combustion synthesis method in step (1) is from 0.4 µm to 20 µm, and α phase content is >60 wt%, an impurity content is <10 wt%, the particle morphology is consistent, and the silicon nitride powder shows equiaxial morphology. The obtained silicon nitride powders are well suited for the preparation of substrates for integrated circuits.

For example, step (1) described above may comprise:
(1.1) Ball milling raw silica powder with original particle size of 100-500 mesh for activation treatment, using alcohol or acetone as medium, ball milling for 12-36 h; the ball-milled slurry is vacuum filtered and dried under vacuum at a temperature of 50-70°C to obtain highly active silica powder with an average particle size of about 0.5-1 µm;
(1.2) Using the activated silicon powder obtained in 1.1 as raw materials, adding an appropriate amount of diluent and additives, the additives comprises at least one of NH₄Cl and NH₄F, a weight percentage of each component is as follows: silicon powder: 20%-55wt%, silicon nitride diluent: 40%-70wt%, additives: 5-10wt%, blended to obtain mixed raw materials;
(1.3) Mixing the raw material obtained from 1.2 in alcohol or acetone medium for 10-20 hours to make it well mixed, and drying the raw material mixture under vacuum at 50-70°C, passing through 50-200 mesh sieve and subsequently loosely packed in graphite boats;
(1.4) placing the graphite boat in 1.3 in the combustion synthesis reaction device, and after evacuation, 0.5-4.5 MPa high-purity nitrogen gas was charged, and the combustion synthesis reaction occurred after ignition; at the end of the combustion reaction, after sufficient cooling, the product was removed, thus producing a silicon nitride powder with an α-phase content greater than 60 wt%.

In the above method of preparing silicon nitride powder and the method of preparing silicon nitride ceramic slurry, coarse sieving the prepared silicon nitride powder in step (2) with a 150-900 mesh sieve and washing the powder with acid to remove the oxide layer as well as the oxygen-containing groups on the surface of the powder; a ratio of volume content of nitric acid, hydrochloric acid and sulfuric acid in the mixed acid is 10%-20%, 60%-80% and 10%-20%, respectively, and a mass fraction of each acid solution is less than 68%, 20% and 70%, respectively; washing with acid for 1-10 hours, the powder after washing with acid is washed 1-5 times to remove water-soluble substances such as water-soluble ionic impurities, and dried by pressure filter drying, spray drying or vacuum drying after filtration.

In the above method of preparing silicon nitride powder and the method of preparing silicon nitride ceramic slurry, performing heat treatment of the α-silicon nitride ceramic powder in step (3) to remove NH₄Cl or NH₄F additives from the initial powder; heating device is a tunnel kiln or heating furnace, and the heat treatment process is heat treatment at 500-900°C for 1-8 hours under flowing nitrogen atmosphere, with a heating rate of 5-10°C/min, where purity of the nitrogen is 99.2%-99.999% and the flow rate is 2-5m/s.

In the above method of preparing silicon nitride powder and the method of preparing silicon nitride ceramic slurry, in step (4), α silicon nitride ceramic powder, sintering aid, solvent, dispersant, binder, and plasticizer are mixed in a mass ratio of 100: (3-15): (20-70): (2-4): (5-20): (5-30), and then placed in planetary ball mill, rolling ball mill, sand mill grinding for 1-10 hours, speed 300-3000r/min, grinding media is silicon nitride grinding balls, sieving with 150-900 mesh sieve to obtain high purity α silicon nitride ceramic slurry. The sintering aid is at least one selected from the group consisting of alumina, yttrium oxide, magnesium oxide, calcium oxide and magnesium silica nitrogen. The solvent is at least one selected from the group consisting of ethanol, ethylene glycol, isopropanol, n-butanol and 2-butanone. The dispersant is at least one selected from the group consisting of triethyl phosphate, polyvinylpyrrolidone, ammonium polyacrylate and ammonium citrate. The binder is at least one selected from the group consisting of polyethylene glycol, polyvinyl butyral and methyl acrylate. The plasticizer is at least one selected from the group consisting of phthalate, polyethylene glycol and glycerol.

In the above method of preparing silicon nitride powder and the method of preparing silicon nitride ceramic slurry, the surface shaping in step (4) comprises sand grinding, stirring grinding, V-mixer mixing grinding and/or roller grinding, preferably sand grinding.

The silicon nitride ceramic slurry obtained using the above method has an impurity content of less than 5 wt%, a solid phase volume fraction of 50-75 %, a viscosity of less than 0.2 pa·s, and an α-phase content of more than 60 wt% in the silicon nitride powder, which is suitable for cast molding and simple to prepare. From the above description, it is clear that the silicon nitride ceramic slurry obtained in the present description has advantages of both high solid phase volume fraction (50-75 %) and low viscosity (less than 0.2 pa·s). In general, the higher the solid phase volume fraction of a ceramic slurry, the higher its viscosity will be, because the increased solid content and the increased agglomeration, etc. weaken the flowability of the slurry. The production of silicon nitride ceramic substrates is commonly done by cast molding, which requires a slurry with both high solid content and low viscosity in order to produce high-quality silicon nitride ceramic substrates. Before the present invention, the technical problem of how to obtain a silicon nitride ceramic slurry with both high solid phase volume fraction and low viscosity has long been a problem for researchers in this field.

Prior to the present invention, researchers have tried various approaches, including conventional mechanical pulping methods, chemical pulping methods, organic solvent pulping methods, etc., to obtain silicon nitride ceramic slurry with both high solid phase volume fraction and low viscosity, but the results were unsatisfactory. Researchers in this field have developed an almost ingrained perception that high solid content and low viscosity are an irreconcilable contradiction, and that it is almost impossible to obtain a silicon nitride ceramic paste with both high solid content and low viscosity.

The present invention provides a silicon nitride powder as described above which is a good solution to the above technical problem. Without being bound by any theory or existing experience, the inventors of the present invention surprisingly found in their research that one of the main reasons for the high viscosity of ceramic slurries with higher solid phase content is that the silicon nitride powder particles used in ceramic slurries have a small particle size and a large specific surface area, and the silicon nitride powder with a large specific surface area comes into contact with an oxidizing environment such as air, forming excessive hydroxyl groups or other oxygen-containing groups on the powder surface, increasing electrostatic energy, agglomeration of powder particles under the force of electrostatic force and hydrogen bonding, etc., impede the fluidity and lubricity between the powders, thus not being able to obtain a silicon nitride ceramic slurry with both high solid phase content and low viscosity.

Based on the unexpected discovery and profound understanding of the above technical problems, the inventors of the present invention provide a new silicon nitride powder as described above, which has a high ratio of unoxidized silicon nitride surface area: entire silicon nitride surface area, thus greatly improving the dispersion of the silicon nitride powder in the ceramic slurry, reducing the viscosity of the ceramic slurry, and increasing the solid phase content of silicon nitride, which is well suited for cast molding of IC substrates. For this new silicon nitride powder, the inventors of the present invention have designed the following simple, ingenious and efficient scheme: first, the silicon nitride powder is premixed with the organic component, and the organic-inorganic mixture is subjected to surface shaping using equipment to fully break the silicon nitride powder therein and expose the internal material of the silicon nitride powder to form a new surface. The inventors of the present invention have found that since the silicon nitride powder is wrapped in organic components during the surface shaping process described above, thereby isolating it from air, the newly exposed silicon nitride surface that has been surface shaped (e.g., ground, crushed) will not be oxidized by oxygen in the air, and the surface will not be susceptible to the formation of a solid phase containing oxygen functional groups. In a simple but effective way, the inventors of the present invention have solved the aforementioned problem that has long plagued researchers in this field: they have succeeded in providing a silicon nitride ceramic slurry with both a high solid phase content and a low viscosity. The ceramic slurry provided by embodiments of the present invention can have a solid phase content (volume fraction) of 50-75 %, while at the same time its viscosity can be less than 0.2 pa·s.

In addition, prior to the aforementioned premixing and grinding, the inventors of the present invention also remove the oxide layer as well as the oxygen-containing groups on the surface of the powder by washing the silicon nitride powder with acid; the washing with acid is followed by washing with water to remove water-soluble ionic impurities; and the washing with water is followed by heat treatment, during the heat treatment, NH₄Cl or NH₄F additives from the initial powder are removed. The above-mentioned washing with acid, washing with water and heat treatment processes prior to premixing and grinding further improve the purity and surface properties of the silicon nitride powder, making it more suitable for the manufacture of ceramic slurry with excellent properties.

It is the use of the surface shaping, washing with acid, washing with water, and heat treatment described above that greatly improves the overall performance of the silicon nitride ceramic slurry and makes the silicon nitride ceramic slurry in the present description suitable for preparation by a wider variety of methods. For example, a combustion synthesis method suitable for large-scale industrial production can be used to prepare silicon nitride powders, which can then be used to further prepare ceramic slurries. Combustion synthesis is a method that uses the heat released from combustion reactions to prepare materials. It uses the instantaneous energy provided by the outside to induce local chemical reactions in highly exothermic chemical reaction systems, forming self-sustaining reaction combustion waves, which then cause the raw materials to react and transform into products as the combustion waves spread forward. The preparation of silicon nitride powder by combustion synthesis has many advantages compared with other preparation methods, such as low cost, energy saving, high efficiency, simple process, high product purity, and suitable for large-scale production. However, before the present invention was proposed, the performance of ceramic slurry made from silicon nitride powders prepared by combustion synthesis method did not meet the requirements for the preparation of integrated circuit substrates. In other words, the preparation of silicon nitride powders by combustion synthesis and the manufacture of silicon nitride ceramic slurries from these powders have the same problem as before: it is difficult to obtain ceramic slurries with high solid phase content and low viscosity at the same time. However, the primary powder of silicon nitride is prepared by combustion synthesis, and then this primary powder of silicon nitride is subjected to surface shaping, washing with acid, washing with water, and heat treatment as described in present description, and a high-quality ceramic slurry suitable for cast molding with a solid phase volume fraction of 50-75 % and a viscosity of less than 0.2 pa·s can be obtained. The solution proposed by the inventors of the present invention allows the combustion synthesis method to be used for the production of silicon nitride powders and furthermore for the mass industrial production of high-quality silicon nitride ceramic pastes suitable for cast molding based on these silicon nitride powders. This contribution is not only technically pioneering, but also commercially valuable.

In the description herein, for the purpose of clarity and conciseness, the newly exposed silicon nitride surface exposed by the above-mentioned surface shaping is referred to as the "unoxidized silicon nitride surface". It is understood that the ratio of the area of the "unoxidized silicon nitride surface" to the area of the "entire silicon nitride surface" will reflect the proportion of the new surface of the silicon nitride powder that is not oxidized by the oxygen in the air during the above-mentioned grinding process to the entire surface. Since the ratio of "surface area" is the same as the ratio of "specific surface area", and the "specific surface area" is more convenient to be determined by scientific means. Therefore, the ratio of "specific surface area" will be used to determine the ratio of "surface area" in the embodiments herein.

In the present description, the term "surface shaping" refers to the process of pre-mixing the silicon nitride powder with organic components and using equipment to mechanically process the organic-inorganic mixture, such as grinding and crushing, to fully crush the silicon nitride powder and expose the internal material of the silicon nitride powder to form new surfaces, while in the process, the above-mentioned new surfaces of the silicon nitride powder interacts physically and chemically with the above-mentioned organic components to form a ceramic slurry with both high solid phase content and low viscosity. The surface shaping includes, for example, sand grinding, stirring grinding, V-mixer mixing grinding and/or roller grinding, preferably sand grinding. The sand grinding is preferred because it can effectively break the silicon nitride powder and obtain a fine powder with a regular surface shape and uniform particle size, as well as enhance the mixing degree of the powder and the organic components. However, the "surface shaping" in the present description is not limited to the above-mentioned limited ways, as long as the treatment can effectively break silicon nitride powder and obtain fine silicon nitride powder with excellent microscopic morphology, the above-mentioned "surface shaping" purpose can be achieved. As can be seen from the above contents, the "surface shaping" described herein not only increases the unoxidized surface of the silicon nitride powder, but also improves the microscopic morphology of the silicon nitride powder, making it more suitable for the preparation of high-performance ceramic slurries. In particular, in order to be able to quantitatively define at least one aspect of the "surface shaping" described herein, after the "surface shaping", a ratio of unoxidized silicon nitride surface area to entire silicon nitride surface area is from 0.40 to 0.85, preferably 0.50-0.80; further preferably 0.55-0.76.

The technical solutions of the present invention have the following outstanding advantages compared with the prior art:
(1). The silicon nitride powder provided by embodiments of the present invention has a high percentage of unoxidized surface, the silicon nitride powder shows an equiaxial regular morphology, and the silicon nitride powder is not easily agglomerated with each other, which is suitable for further preparation of high-quality silicon nitride ceramic slurry.
(2). The preparation of silicon nitride powders by temperature-controlled activation combustion synthesis achieved combustion synthesis at lower temperatures, substantially reduced the residence time of synthesis products in the high temperature interval, avoided large hard agglomerates caused by high temperature calcination, and prepared silicon nitride powders for substrates with high purity, high α-phase content, and good consistency of particle morphology.
(3). The purity of the initial powders of silicon nitride ceramic slurries for substrates is greatly improved by washing with acid, washing with water, and heat treatment processes. The washing with acid process removes the oxide layer as well as oxygen-containing groups on the surface of the powder; the washing with water process removes water-soluble ionic impurities; and the heat treatment removes NH₄Cl or NH₄F additives from the initial powder.
(4). The silicon nitride ceramic slurry for substrates was prepared by grinding and co-blending silicon nitride ceramic powder, solvent and additives using a grinder, during which the silicon nitride powder was wrapped by organic components, thus isolated from air, and the fresh surface of the finely ground silicon nitride was not easily formed with oxygen-containing functional groups, which hindered the agglomeration of silicon nitride powder and greatly improved the dispersion uniformity and stability of silicon nitride ceramic slurry.
(5). The prepared silicon nitride ceramic slurries for substrates have high α-phase content, high purity, low viscosity, high solid phase content, suitable for flow molding, and simple preparation method for industrial production.

### BRIEF DESCRIPTION OF THE DRAWINGS

In order to illustrate the technical solutions of the embodiments of the present invention more clearly, the following drawings of the embodiments will be briefly described. Obviously, the drawings in the following description relate only to some embodiments of the present invention and are not a limitation of the present invention.
Fig. 1 is a microscopic morphology of the silicon nitride powder synthesized by temperature-controlled activation combustion in Example 3.
Fig. 2 is an XRD analysis profile of the silicon nitride powder synthesized by temperature-controlled activation combustion in Example 3.

### DETAILED DESCRIPTION

The silicon nitride and silicon nitride ceramic slurry of the present invention will be described further below in connection with specific embodiments. It should be understood that the following embodiments are intended to illustrate and explain the present invention only exemplarily and should not be construed as limiting the scope of protection of the present invention. Any technology implemented based on the above elements of the present invention is covered by the scope of protection of the present invention.

### Example 1

High-purity α-silicon nitride powders with a particle size of 3 µm, an α-phase content of 85%, an impurity content of 2%, and a uniform particle morphology were prepared by a temperature-controlled activation combustion synthesis method under 1 MPa nitrogen pressure. The silicon nitride powder was coarsely sieved with a 600 mesh sieve and placed in a mixture of nitric, hydrochloric, and sulfuric acids (20%, 60%, and 20% by volume, and 40%, 15%, and 58% by mass, respectively) for 3 hours, followed by 3 times of washing with water, and dried by vacuum drying after extraction. After that, the silicon nitride powder was heat-treated in a heating furnace for 5 h at 600°C under a flowing nitrogen atmosphere with a heating rate of 8°C/min, where the nitrogen purity was 99.999% and the flow rate was 3 m/s. The specific surface area of the obtained silicon nitride powder was tested to be S₁=0.625 m²/g.

Then, the α-silicon nitride ceramic powder, solvent, dispersant, binder and plasticizer (ethanol as solvent, triethyl phosphate and polyvinylpyrrolidone as dispersant, polyvinyl butyral as binder, polyethylene glycol and glycerol as plasticizer) were weighed in a mass ratio of 100:50:3:15:20 and mixed in a sand mill with a speed of 800 r/min with silicon nitride grinding balls for 2 hours. A small amount of sample was taken and the solvent, dispersant, binder and plasticizer were removed by methods such as combustion or distillation separation to obtain the silicon nitride powder, which was tested to have a specific surface area of S₂=2.180 m²/g. (S₂-S₁)/S₂=0.713. It is easy to understand that the newly added silicon nitride surface (i.e. S₂-S₁) after grinding is an unoxidized surface as it is always wrapped by solvent, dispersant and other components and isolated from outside air, i.e. the "unoxidized silicon nitride surface" as defined in the "summary of the disclosure" section of the present invention.

Finally, the sintering aid is added according to a mass ratio of α-silicon nitride ceramic powder: sintering aid =100:10, the sintering aid is alumina and magnesium silica nitrogen, mixed and placed in a sand mill at a speed of 800r/min grinding for 1 hour with silicon nitride grinding balls. The high purity α-silicon nitride ceramic slurry CX1 was obtained by passing it through a 600 mesh sieve. The characterization results of the silicon nitride ceramic slurry were: 3 wt% impurity content, 50.5% solid phase volume fraction, and 0.125 pa·s viscosity.

### Example 2

High-purity α-silicon nitride powders with a particle size of 5 µm, an α-phase content of 90%, an impurity content of 1.6%, and a uniform particle morphology were prepared by a temperature-controlled activation combustion synthesis method under 3 MPa nitrogen pressure. The silicon nitride powder was coarsely sieved with a 600 mesh sieve and placed in a mixture of nitric, hydrochloric, and sulfuric acids (20%, 60%, and 20% by volume, and 40%, 15%, and 58% by mass, respectively) for 5 hours, followed by 5 times of washing with water, and dried by vacuum drying after extraction. After that, the silicon nitride powder was heat-treated in a heating furnace for 4 h at 700°C under a flowing nitrogen atmosphere with a heating rate of 8°C/min, where the nitrogen purity was 99.999% and the flow rate was 3 m/s. The specific surface area of the obtained silicon nitride powder was tested to be S₁=0.375 m²/g.

Then, the α-silicon nitride ceramic powder, solvent, dispersant, binder and plasticizer (ethanol as solvent, triethyl phosphate and polyvinylpyrrolidone as dispersant, polyvinyl butyral as binder, polyethylene glycol and glycerol as plasticizer) were weighed in a mass ratio of 100:40:3:10:15 and mixed in a sand mill with a speed of 1000 r/min with silicon nitride grinding balls for 3 hours. A small amount of sample was taken and the solvent, dispersant, binder and plasticizer were removed by methods such as combustion or distillation separation to obtain the silicon nitride powder, which was tested to have a specific surface area of S₂=1.562 m²/g. (S₂-S₁)/S₂=0.760.

Finally, the sintering aid is added according to a mass ratio of α-silicon nitride ceramic powder: sintering aid =100:10, the sintering aid is alumina and magnesium oxide, mixed and placed in a sand mill at a speed of 1000r/min grinding for 1 hour with silicon nitride grinding balls. The high purity α-silicon nitride ceramic slurry CX2 was obtained by passing it through a 600 mesh sieve. The characterization results of the silicon nitride ceramic slurry were: 1 wt% impurity content, 57% solid phase volume fraction, and 0.14 pa·s viscosity.

### Example 3

High-purity α-silicon nitride powders with a particle size of 1.5 µm, an α-phase content of 93%, an impurity content of 1.3%, and a uniform particle morphology were prepared by a temperature-controlled activation combustion synthesis method under 0.6 MPa nitrogen pressure. The silicon nitride powder was coarsely sieved with a 600 mesh sieve and placed in a mixture of nitric, hydrochloric, and sulfuric acids (20%, 60%, and 20% by volume, and 40%, 15%, and 58% by mass, respectively) for 5 hours, followed by 5 times of washing with water, and dried by vacuum drying after extraction. After that, the silicon nitride powder was heat-treated in a heating furnace for 6 h at 800°C under a flowing nitrogen atmosphere with a heating rate of 8°C/min, where the nitrogen purity was 99.999% and the flow rate was 3 m/s. The specific surface area of the obtained silicon nitride powder was tested to be S₁=1.250 m²/g.

Then, the α-silicon nitride ceramic powder, solvent, dispersant, binder and plasticizer (ethanol as solvent, triethyl phosphate and polyvinylpyrrolidone as dispersant, polyvinyl butyral as binder, polyethylene glycol and glycerol as plasticizer) were weighed in a mass ratio of 100:30:2:8:10 and mixed in a sand mill with a speed of 1500 r/min with silicon nitride grinding balls for 4 hours. A small amount of sample was taken and the solvent, dispersant, binder and plasticizer were removed by methods such as combustion or distillation separation to obtain the silicon nitride powder, which was tested to have a specific surface area of S₂=2.880 m²/g. (S₂-S₁)/S₂=0.566.

Finally, the sintering aid is added according to a mass ratio of α-silicon nitride ceramic powder: sintering aid =100:5, the sintering aid is yttrium oxide and magnesium oxide, mixed and placed in a sand mill at a speed of 1500r/min grinding for 1 hour with silicon nitride grinding balls. The high purity α-silicon nitride ceramic slurry CX3 was obtained by passing it through a 600 mesh sieve. The characterization results of the silicon nitride ceramic slurry were: 0.9 wt% impurity content, 64.5% solid phase volume fraction, and 0.165 pa·s viscosity.

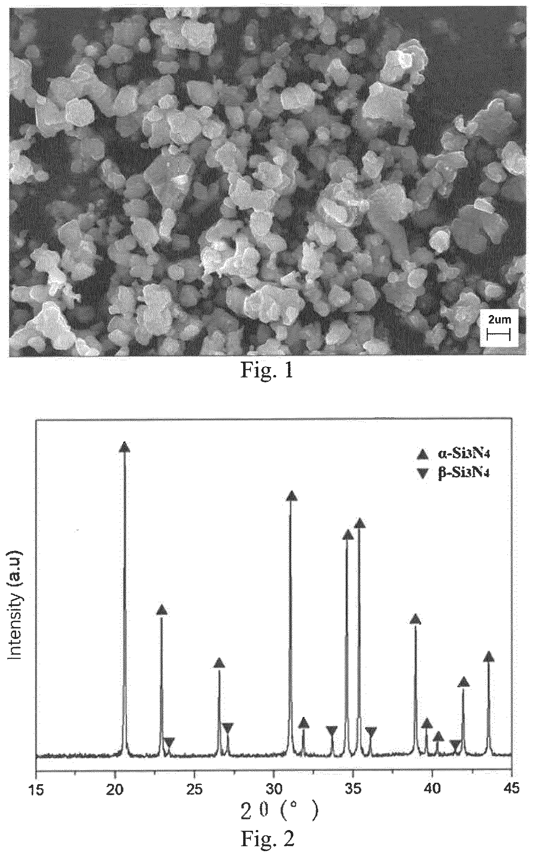

The particle size of the above obtained silicon nitride powder was characterized by scanning electron microscopy and the results are shown in Fig. 1. As can be seen from Fig. 1, the silicon nitride powder obtained in present embodiment exhibits an equiaxial morphology, with most of the particles less than 2 µm in diameter and some of them less than 1 µm in diameter. The phase composition and content of the above obtained silicon nitride powders were analyzed by X-ray diffraction characterization, and the results are shown in Fig. 2. As can be seen from Fig. 2, the vast majority of the silicon nitride obtained in the present embodiment is α-phase silicon nitride, with β-phase silicon nitride accounting for less than 7 wt%.

### Example 4

High-purity α-silicon nitride powders with a particle size of 1.3 µm, an α-phase content of 95%, an impurity content of 1.1%, and a uniform particle morphology were prepared by a temperature-controlled activation combustion synthesis method under 0.5 MPa nitrogen pressure. The silicon nitride powder was coarsely sieved with a 600 mesh sieve and placed in a mixture of nitric, hydrochloric, and sulfuric acids (20%, 60%, and 20% by volume, and 40%, 15%, and 58% by mass, respectively) for 5 hours, followed by 5 times of washing with water, and dried by vacuum drying after extraction. After that, the silicon nitride powder was heat-treated in a heating furnace for 5 h at 900°C under a flowing nitrogen atmosphere with a heating rate of 8°C/min, where the nitrogen purity was 99.999% and the flow rate was 3 m/s. The specific surface area of the obtained silicon nitride powder was tested to be S₁=1.442 m²/g.

Then, the α-silicon nitride ceramic powder, solvent, dispersant, binder and plasticizer (ethanol as solvent, triethyl phosphate and polyvinylpyrrolidone as dispersant, polyvinyl butyral as binder, polyethylene glycol and glycerol as plasticizer) were weighed in a mass ratio of 100:20:2:6:8 and mixed in a sand mill with a speed of 2000 r/min with silicon nitride grinding balls for 5 hours. A small amount of sample was taken and the solvent, dispersant, binder and plasticizer were removed by methods such as combustion or distillation separation to obtain the silicon nitride powder, which was tested to have a specific surface area of S₂=3.233 m²/g. (S₂-S₁)/S₂=0.553.

Finally, the sintering aid is added according to a mass ratio of α-silicon nitride ceramic powder: sintering aid =100:4, the sintering aid is alumina and magnesium oxide, mixed and placed in a sand mill at a speed of 2000r/min grinding for 1 hour with silicon nitride grinding balls. The high purity α-silicon nitride ceramic slurry CX4 was obtained by passing it through a 600 mesh sieve. The characterization results of the silicon nitride ceramic slurry were: 0.86 wt% impurity content, 72.5% solid phase volume fraction, and 0.180 pa·s viscosity.

### Example 5

High-purity α-silicon nitride powders with a particle size of 3 µm, an α-phase content of 85%, an impurity content of 2%, and a uniform particle morphology were prepared by a temperature-controlled activation combustion synthesis method under 1 MPa nitrogen pressure. The silicon nitride powder was coarsely sieved with a 600 mesh sieve and placed in a mixture of nitric, hydrochloric, and sulfuric acids (20%, 60%, and 20% by volume, and 40%, 15%, and 58% by mass, respectively) for 3 hours, followed by 3 times of washing with water, and dried by vacuum drying after extraction. After that, the silicon nitride powder was heat-treated in a heating furnace for 5 h at 600°C under a flowing nitrogen atmosphere with a heating rate of 8°C/min, where the nitrogen purity was 99.999% and the flow rate was 3 m/s.

Then, the α-silicon nitride ceramic powder, sintering aid, solvent, dispersant, binder and plasticizer (alumina and magnesium silica nitrogen as sintering aid, ethanol as solvent, triethyl phosphate and polyvinylpyrrolidone as dispersant, polyvinyl butyral as binder, polyethylene glycol and glycerol as plasticizer) were weighed in a mass ratio of 100:10:50:3:15:20 and mixed in a sand mill with a speed of 800 r/min with silicon nitride grinding balls for 3 hours.

Finally, the high purity α-silicon nitride ceramic slurry CX5 was obtained by passing it through a 600 mesh sieve. The characterization results of the silicon nitride ceramic slurry were: 3 wt% impurity content, 50.3% solid phase volume fraction, and 0.130 pa·s viscosity.

The content of the present embodiment is basically the same as that of Example 1, with the difference that the step of testing the specific surface area S₁ and S₂ of the silicon nitride powder before and after grinding is added to Example 1. It should be noted that the test steps of specific surface area S₁ and S₂ of silicon nitride powder before and after grinding are added only to explore the reasons for the good technical results obtained by the technical solutions of the present invention. In actual production process, this step can be completely omitted, as in the present embodiment, directly mixing and grinding the silicon nitride ceramic powder with the reagents essential for forming the ceramic slurry to obtain the final ceramic slurry product.

### Example 6

High-purity α-silicon nitride powders with a particle size of 3 µm, an α-phase content of 85%, an impurity content of 2%, and a uniform particle morphology were prepared by a temperature-controlled activation combustion synthesis method under 1 MPa nitrogen pressure. The silicon nitride powder was coarsely sieved with a 600 mesh sieve and placed in a mixture of nitric, hydrochloric, and sulfuric acids (20%, 60%, and 20% by volume, and 40%, 15%, and 58% by mass, respectively) for 3 hours, followed by 3 times of washing with water, and dried by vacuum drying after extraction. After that, the silicon nitride powder was heat-treated in a heating furnace for 5 h at 600°C under a flowing nitrogen atmosphere with a heating rate of 8°C/min, where the nitrogen purity was 99.999% and the flow rate was 3 m/s.

Then, the α-silicon nitride ceramic powder and solvent (ethanol as the solvent) were mixed according to a mass ratio of 100:85 and placed in a sand mill with a speed of 800 r/min and ground with silicon nitride grinding balls for 3 hours. In an anaerobic environment (e.g., in a nitrogen-filled glove box), the solvent, dispersant, binder and plasticizer are removed by combustion or distillation separation, and the silicon nitride powder is obtained and packaged anaerobically (e.g., in a bag filled with nitrogen) or vacuum-sealed. In an oxygen-free environment, take the above-mentioned silicon nitride powder inside the vacuum-sealed package. The α-silicon nitride ceramic powder, sintering aid, solvent, dispersant, binder and plasticizer (alumina and magnesium silica nitrogen as sintering aid, ethanol as solvent, triethyl phosphate and polyvinylpyrrolidone as dispersant, polyvinyl butyral as binder, polyethylene glycol and glycerol as plasticizer) were weighed in a mass ratio of 100:10:50:3:15:20 and mixed in a sand mill with a speed of 800 r/min with silicon nitride grinding balls for 3 hours.

Finally, the high purity α-silicon nitride ceramic slurry CX6 was obtained by passing it through a 600 mesh sieve. The characterization results of the silicon nitride ceramic slurry were: 3 wt% impurity content, 51.1% solid phase volume fraction, and 0.126 pa·s viscosity.

Based on the present embodiment, it can be understood that the silicon nitride powder herein can be vacuum anaerobically sealed and packaged and sold separately. Users can formulate their own ceramic slurry in an anaerobic environment according to their specific needs. For the components of the ceramic slurry, the ratio between the components, the users can flexibly select and determine. This leaves a large degree of freedom for the users.

### Comparative Example 1 No surface shaping (simple mixing)

High-purity α-silicon nitride powders with a particle size of 3 µm, an α-phase content of 85%, an impurity content of 2%, and a uniform particle morphology were prepared by a temperature-controlled activation combustion synthesis method under 1 MPa nitrogen pressure. The silicon nitride powder was coarsely sieved with a 600 mesh sieve and placed in a mixture of nitric, hydrochloric, and sulfuric acids (20%, 60%, and 20% by volume, and 40%, 15%, and 58% by mass, respectively) for 3 hours, followed by 3 times of washing with water, and dried by vacuum drying after extraction. After that, the silicon nitride powder was heat-treated in a heating furnace for 5 h at 600°C under a flowing nitrogen atmosphere with a heating rate of 8°C/min, where the nitrogen purity was 99.999% and the flow rate was 3 m/s. The specific surface area of the obtained silicon nitride powder was tested to be S₁=0.625 m²/g.

Then, the α-silicon nitride ceramic powder, solvent, dispersant, binder and plasticizer (ethanol as solvent, triethyl phosphate and polyvinylpyrrolidone as dispersant, polyvinyl butyral as binder, polyethylene glycol and glycerol as plasticizer) were weighed in a mass ratio of 100:50:3:15:20 and mixed. A small amount of sample was taken and the solvent, dispersant, binder and plasticizer were removed by methods such as combustion or distillation separation to obtain the silicon nitride powder, which was tested to have a specific surface area of S₂=0.625 m²/g. (S₂-S₁)/S₂=0.

Finally, the sintering aid is added according to a mass ratio of α-silicon nitride ceramic powder: sintering aid =100:10, the sintering aid is alumina and magnesium silica nitrogen, mixed thoroughly. The high purity α-silicon nitride ceramic slurry CX1' was obtained by passing it through a 600 mesh sieve. The characterization results of the silicon nitride ceramic slurry were: 2.8 wt% impurity content, 43.6% solid phase volume fraction, and 0.974 pa·s viscosity.

The contents of Comparative Example 1 are basically the same as that of Example 1, the difference being that in Comparative Example 1, no grinding using a sand mill was performed, i.e. no surface shaping was performed. Comparing the results of Example 1 with those of Comparative Example 1, it can be seen that the solid phase volume fraction of Comparative Example 1 is lower than that of Example 1, while the viscosity is significantly higher than that of Example 1.

**Table 1: Product properties of high purity α silicon nitride ceramic slurries for substrates**

| Samples | Particle size of silicon nitride (µm) | α phase content (wt %) | Impurity of the slurry (wt %) | Solid phase volume fraction( %) | Viscosity (pa·s) |
|---|---|---|---|---|---|
| CX1 | 3 | 85 | 3 | 50.5 | 0.125 |
| CX2 | 5 | 90 | 1 | 57 | 0.140 |
| CX3 | 1.5 | 93 | 0.90 | 64.5 | 0.165 |
| CX4 | 1.3 | 95 | 0.86 | 72.5 | 0.180 |
| CX5 | 3 | 85 | 3 | 50.3 | 0.130 |
| CX6 | 3 | 85 | 3 | 51.1 | 0.126 |
| CX1' | 3 | 85 | 2.8 | 43.6 | 0.974 |

## Claims

1. Silicon nitride powder, wherein, a ratio of unoxidized silicon nitride surface area to entire silicon nitride surface area is from 0.40 to 0.85; preferably, the ratio of the unoxidized silicon nitride surface area to the entire silicon nitride surface area is from 0.50 to 0.80; further preferably, the ratio of the unoxidized silicon nitride surface area to the entire silicon nitride surface area is from 0.55 to 0.76.

2. The silicon nitride powder of claim 1, wherein, a particle size of the silicon nitride powder is in the range of from 0.4 µm to 20 µm; preferably from 1 µm to 10 µm; further preferably from 1.3 µm to 5 µm;
preferably, a specific surface area of the silicon nitride powder is 0.5 m²/g - 8.0 m²/g; preferably, the specific surface area of the silicon nitride powder is 0.8 m²/g - 6.0 m²/g; preferably, the specific surface area of the silicon nitride powder is 1.0 m²/g - 5.0 m²/g; preferably, the specific surface area of the silicon nitride powder is 1.1 m²/g - 4.0 m²/g;
preferably, an α phase content of the silicon nitride powder is >60 wt%, preferably >80 wt%, more preferably 85 wt% - 95 wt %.

3. A ceramic slurry, wherein, the ceramic slurry comprises a silicon nitride powder of claim 1 or 2, a sintering aid and an organic component, wherein the organic component has at least one of groups selected from hydroxyl, carboxyl, amino, ester, aldehyde and carbonyl; preferably, the organic component has at least one of groups selected from hydroxyl, carboxyl, amino and ester; further preferably, the organic component has at least one of groups selected from hydroxyl and carboxyl.

4. The ceramic slurry of claim 3, wherein, the organic component comprises a solvent, a dispersant, a binder and a plasticizer; preferably, a mass ratio of the silicon nitride powder, the sintering aid, the solvent, the dispersant, the binder and the plasticizer is 100: (3-15): (20-70): (2-4): (5-20): (5-30);
preferably, the sintering aid is at least one selected from the group consisting of alumina, yttrium oxide, magnesium oxide, calcium oxide and magnesium silica nitrogen; preferably, the solvent is at least one selected from the group consisting of ethanol, ethylene glycol, isopropanol, n-butanol and 2-butanone; preferably, the dispersant is at least one selected from the group consisting of triethyl phosphate, polyvinylpyrrolidone, ammonium polyacrylate and ammonium citrate; preferably, the binder is at least one selected from the group consisting of polyethylene glycol, polyvinyl butyral and methyl acrylate; preferably, the plasticizer is at least one selected from the group consisting of phthalate, polyethylene glycol and glycerol;
preferably, the ceramic slurry has an impurity content of less than 5 wt%, a solid phase volume fraction of 50 %-75 % and a viscosity of less than 0.2 pa·s.

5. A method for preparing silicon nitride powder of claim 1 or 2, wherein, the method comprises:
(1) preparing a silicon nitride primary powder by a temperature-controlled activation combustion synthesis method;
(2) sieving the silicon nitride primary powder, washing with a mixture of nitric acid, hydrochloric acid and sulfuric acid, followed by washing with water, filtration and drying;
(3) placing powder obtained in step (2) in a heating device and removing the additives by heat treatment under flowing nitrogen;
(4) mixing powder obtained in step (3) with a fluid for surface shaping and sieving to obtain a slurry containing silicon nitride powder, the fluid comprises organic matter;
(5) heating the slurry containing silicon nitride powder obtained in step (4) in an oxygen-free environment, removing the fluid, sealing and packaging to obtain the silicon nitride powder.

6. The method of claim 5, wherein, a particle size of the silicon nitride primary powder in step (1) is in the range of from 0.1 µm to 20 µm; preferably from 1 µm to 10 µm; further preferably from 1.3 µm to 5 µm; an α phase content is >60 wt%, preferably >80 wt%, more preferably 85 wt% - 95 wt %; impurity <10%; preferably, the silicon nitride primary powder shows equiaxial morphology; preferably, the surface shaping in step (4) comprises sand grinding, stirring grinding, V-mixer mixing grinding and/or roller grinding, preferably sand grinding;
preferably, during the preparation of silicon nitride primary powder by temperature-controlled activation combustion synthesis in step (1), nitrogen pressure is 0.5 MPa - 8 MPa, preferably 0.6 MPa - 3 MPa;
preferably, step (2) comprises: coarse sieving the silicon nitride primary powder with a 150-900 mesh sieve and washing with a mixture of nitric acid, hydrochloric acid and sulfuric acid to remove oxide layer as well as oxygen-containing groups on surface of the silicon nitride primary powder ; volume fractions of the nitric acid, the hydrochloric acid, and the sulfuric acid in the acid mixture are 10%-20%, 60%-80%, and 10%-20%, respectively, and mass fractions are less than 68%, less than 20%, and less than 70%, respectively, washing with the acid mixture for 1-10 h, washing the obtained powder with water for 1-5 times, removing water-soluble substances, filtering and drying by pressure filter drying, spray drying or vacuum drying;
preferably, step (3) comprises: placing the powder obtained in step (2) in a heating device and heat treated under flowing nitrogen atmosphere to remove the additives, the additives comprise NH₄Cl and/or NH₄F; the heating device comprises a tunnel kiln or heating furnace; the heat treatment comprises: under flowing nitrogen atmosphere, heat treatment at 500°C - 900°C for 1-8 hours, with a heating rate of 5°C/min -10°C/min, wherein nitrogen purity is 99.2 wt% -99.999 wt%, flow rate of 2 m/s -5m/s;
preferably, the organic matter in step (4) is selected from at least one selected from the group consisting of triethyl phosphate, polyvinylpyrrolidone, ammonium polyacrylate and ammonium citrate.

7. A method for preparing the ceramic slurry of claim 3 or 4, wherein, the method comprises:
(1) preparing a silicon nitride primary powder by a temperature-controlled activation combustion synthesis method;
(2) sieving the silicon nitride primary powder, washing with a mixture of nitric acid, hydrochloric acid and sulfuric acid, followed by washing with water, filtration and drying;
(3) placing powder obtained in step (2) in a heating device and removing the additives by heat treatment under flowing nitrogen;
(4) mixing powder obtained in step (3) with a fluid for surface shaping and sieving to obtain the ceramic slurry of any one of claims 5-7, the fluid comprises organic matter.

8. The method of claim 7, wherein, a particle size of the silicon nitride primary powder in step (1) is in the range of from 0.1 µm to 20 µm; preferably from 1 µm to 10 µm; further preferably from 1.3 µm to 5 µm; an α phase content is >60 wt%, preferably >80 wt%, more preferably 85 wt% - 95 wt %; impurity <10%; preferably, the silicon nitride primary powder shows equiaxial morphology; preferably, the surface shaping in step (4) comprises sand grinding, stirring grinding, V-mixer mixing grinding and/or roller grinding, preferably sand grinding;
preferably, during the preparation of silicon nitride primary powder by temperature-controlled activation combustion synthesis in step (1), nitrogen pressure is 0.5 MPa - 8 MPa, preferably 0.6 MPa - 3 MPa;
preferably, step (2) comprises: coarse sieving the silicon nitride primary powder with a 150-900 mesh sieve and washing with a mixture of nitric acid, hydrochloric acid and sulfuric acid to remove oxide layer as well as oxygen-containing groups on surface of the silicon nitride primary powder; volume fractions of the nitric acid, the hydrochloric acid, and the sulfuric acid in the acid mixture are 10%-20%, 60%-80%, and 10%-20%, respectively, and mass fractions are less than 68%, less than 20%, and less than 70%, respectively, washing with the acid mixture for 1-10 h, washing the obtained powder with water for 1-5 times, removing water-soluble substances, filtering and drying by pressure filter drying, spray drying or vacuum drying;
preferably, step (3) comprises: placing the powder obtained in step (2) in a heating device and heat treated under flowing nitrogen atmosphere to remove the additives, the additives comprise NH₄Cl and/or NH₄F; the heating device comprises a tunnel kiln or heating furnace; the heat treatment comprises: under flowing nitrogen atmosphere, heat treatment at 500°C - 900°C for 1-8 hours, with a heating rate of 5°C/min -10°C/min, wherein nitrogen purity is 99.2 wt% -99.999 wt%, flow rate of 2 m/s -5m/s;
preferably, the fluid of step (4) comprises sintering aid, solvent, dispersant, binder and plasticizer, mixing the powder obtained in step (3), the sintering aid, the solvent, the dispersant, the binder and the plasticizer in a mass ratio of 100: (3-15): (20-70): (2-4): (5-20): (5-30);
preferably, the sintering aid is at least one selected from the group consisting of alumina, yttrium oxide, magnesium oxide, calcium oxide and magnesium silica nitrogen; preferably, the solvent is at least one selected from the group consisting of ethanol, ethylene glycol, isopropanol, n-butanol and 2-butanone; preferably, the dispersant is at least one selected from the group consisting of triethyl phosphate, polyvinylpyrrolidone, ammonium polyacrylate and ammonium citrate; preferably, the binder is at least one selected from the group consisting of polyethylene glycol, polyvinyl butyral and methyl acrylate; preferably, the plasticizer is at least one selected from the group consisting of phthalate, polyethylene glycol and glycerol;
preferably, step (4) comprises: the powder obtained in step (3), the sintering aid, the solvent, the dispersant, the binder and the plasticizer are mixed and placed in a sand mill grinding for 1-10 hours, speed 300-3000 r/min, grinding media is silicon nitride grinding ball, sieving with 150-900 mesh sieve to obtain the ceramic slurry.

9. A silicon nitride sintered body, the silicon nitride sintered body is obtained by sintering a ceramic slurry comprising the silicon nitride powder of claim 1 or 2 or the ceramic slurry of claim 3 or 4.

10. A circuit substrate, using the silicon nitride sintered body of claim 9.
